# DEMANDE DE BREVET EUROPEEN

(11) **EP 4 580 327 A1**
(43) Date de publication de la demande: **02.07.2025**
(21) Numéro de dépôt: 24221921.0
(22) Date de dépôt: 19.12.2024
(51) Int. Cl.: H05K 7/20

(54) **SYSTÈME ÉLECTRONIQUE ET PROCÉDÉ D ASSEMBLAGE ASSOCIÉ**

(30) Priorité: 21.12.2023 FR 2314960
(71) Demandeur: Valeo eAutomotive Germany GmbH, 91056 Erlangen (DE)
(72) Inventeur: MASSOL, Laurent, 94046 Créteil Cedex (FR); PIERRE, Thomas, 95892 Cergy-Pontoise (FR); MORELLE, Jean Michel, 94046 Créteil Cedex (FR); ROLINET-GUO, Jingjin, 95892 Cergy-Pontoise (FR); KOPP, Gabriel, 94046 Créteil Cedex (FR)
(74) Mandataire: Valeo Powertrain Systems

(57) **Abrégé**

L'invention concerne un système électronique (1) comprenant :
- un dissipateur thermique (11) comprenant au moins un premier organe de positionnement (111) définissant au moins une position de référence sur le dissipateur thermique,
- au moins un module électronique (12), configuré pour être utilisé avec un dispositif électronique, le module électronique étant fixé au dissipateur et comprenant au moins un deuxième organe de positionnement (121) configuré pour coopérer avec le premier organe de positionnement,
- un adaptateur (13) comprenant au moins une broche électrique de commande (133) et configuré pour faire une liaison électrique entre le module électronique et un dispositif électronique, l'adaptateur comprenant au moins un troisième organe de positionnement (131) configuré pour coopérer :
- avec un quatrième organe de positionnement (122) définissant une position de référence sur le module électronique, et/ou
- avec un cinquième organe de positionnement définissant une position de référence sur le dissipateur thermique.

## Description

### DOMAINE DE L'INVENTION

La présente invention concerne le domaine de l'électronique de puissance et notamment le domaine des équipements d'alimentation de moteur électrique. La présente invention concerne plus particulièrement un système électronique ainsi qu'un procédé d'assemblage d'un tel système.

L'invention peut trouver son application, par exemple, dans les systèmes électroniques pour onduleurs de traction, pour chargeurs embarqués, pour pompes électriques de refroidissement, par exemple, de batterie, pour pompes à chaleur, pour capteurs laser, par exemple pour conduite autonome, etc...

### ETAT DE LA TECHNIQUE

Les systèmes électroniques peuvent comprendre des modules électroniques dit « à large bande ». Ces modules électroniques peuvent comprendre des puces semi conductrices, par exemple, en carbure de silicium ou en nitrure de gallium. Pour de tels modules, les pistes de connexion (ou « *leadframe* » selon la terminologie anglosaxonne) ne peuvent plus être utilisées pour contrôler ou piloter les puces, du fait de leur effet inductif. Il convient donc d'utiliser des broches électriques de commande ou de pilotage les plus droites et les plus courtes possibles. Ces broches électriques sortent à la verticale du module électronique et sont généralement assemblées à l'aide de manchons (ou « *sleeves* » selon la terminologie anglosaxonne) soudées sur le module électronique.

Lors de leur utilisation, les modules électroniques sont généralement fixés à un dissipateur et ensuite assemblés à une carte électronique par l'intermédiaire de connecteurs et/ou de vias.

Du fait des nombreuses dispersions mécaniques, liées notamment à la conception interne des modules électroniques et à leur assemblage sur le dissipateur un problème se pose lors de l'assemblage d'un module électronique à sa carte électronique. En effet, il n'est pas toujours certain de voir les broches électriques s'insérer correctement dans les connexions de la carte électronique.

Un but de l'invention est notamment de corriger tout ou partie des inconvénients de l'art antérieur en proposant une solution permettant de réduire les dispersions de placement liées notamment au processus d'assemblage du ou des modules électroniques et du système électronique.

### BREVE DESCRIPTION DE L'INVENTION

À cet effet, la présente invention a pour objet un système électronique comprenant :
- au moins un dissipateur thermique comprenant au moins un premier organe de positionnement définissant au moins une position de référence sur le dissipateur thermique,
- au moins un module électronique, configuré pour être utilisé avec un dispositif électronique, le module électronique étant fixé au dissipateur et comprenant au moins un deuxième organe de positionnement configuré pour coopérer avec le premier organe de positionnement,
- un adaptateur comprenant au moins une broche électrique de commande et configuré pour faire une liaison électrique entre le module électronique et un dispositif électronique, l'adaptateur comprenant au moins un troisième organe de positionnement configuré pour coopérer :
- avec un quatrième organe de positionnement situé sur le module électronique, ledit quatrième organe de positionnement définissant une position de référence sur le module électronique, et/ou
- avec un cinquième organe de positionnement situé sur le dissipateur thermique ledit cinquième organe de positionnement définissant une position de référence sur le dissipateur thermique.

Suivant un mode de réalisation, les premier et cinquième organes de positionnement sont confondus.

Suivant un mode de réalisation, le au moins un troisième organe de positionnement est situé à moins de dix millimètres d'une broche électrique de commande de l'adaptateur.

Suivant un mode de réalisation, l'adaptateur comprend au moins deux troisièmes organes de positionnement, chacun des au moins deux troisièmes organes de positionnement étant situé à une extrémité de l'adaptateur.

Suivant un mode de réalisation, un des au moins deux troisièmes organes de positionnement est de forme cylindrique et un des au moins deux troisièmes organes de positionnement est de forme oblongue.

Suivant un mode de réalisation, l'adaptateur comprend au moins deux broches électriques de commande, lesdites broches électriques de commande étant alignées et surmoulées ensemble dans l'adaptateur.

Suivant un mode de réalisation, les broches électriques de commande et le au moins un deuxième organe de positionnement de l'adaptateur sont surmoulées ensemble dans l'adaptateur.

Suivant un mode de réalisation, le module électronique comprend un module de puissance ou un module d'excitation.

Suivant un mode de réalisation, l'adaptateur est fixé au module électronique par l'intermédiaire de l'au moins une broche électrique de commande.

Suivant un mode de réalisation, un des premier et deuxième organes de positionnement est un organe de forme male et l'autre est un organe de forme femelle.

Suivant un mode de réalisation, les premier et deuxième organes de positionnement sont de forme femelle.

Suivant un mode de réalisation, les premier et deuxième organes de positionnement sont coaxiaux.

Suivant un mode de réalisation, un des troisième et quatrième organes de positionnement est un organe de forme male et l'autre est un organe de forme femelle.

Suivant un mode de réalisation, les troisième et quatrième organes de positionnement sont coaxiaux.

L'invention a également pour objet, un procédé d'assemblage d'un système électronique comportant les étapes suivantes:
- fournir au moins un dissipateur thermique comprenant au moins un premier organe de positionnement définissant une position de référence sur le dissipateur thermique;
- fournir au moins un module électronique comprenant au moins un deuxième organe de positionnement configuré pour coopérer avec le premier organe de positionnement;
- positionner le module électronique au contact du dissipateur thermique en faisant coopérer les premier et deuxième organes de positionnement,
- fixer le module électronique avec le dissipateur thermique,
- fournir au moins un adaptateur comprenant au moins une broche électrique de commande et configuré pour faire une liaison électrique entre le module électronique et un dispositif électronique, l'adaptateur comprenant au moins un troisième organe de positionnement configuré pour coopérer
- avec un quatrième organe de positionnement situé sur le module électronique, ledit quatrième organe de positionnement définissant une position de référence sur le module électronique, et/ou
- avec un cinquième organe de positionnement situé sur le dissipateur thermique ledit cinquième organe de positionnement définissant une position de référence sur le dissipateur thermique,
- positionner l'adaptateur au contact du module électronique en faisant coopérer les troisième et quatrième organes de positionnement et/ou les troisième et cinquième organes de positionnement.

Selon un mode de mise en oeuvre du procédé, lors de l'étape de positionnement du module électronique au contact du dissipateur thermique, un premier outillage d'indexation fait coopérer les premier et deuxième organes de positionnement.

Selon un mode de mise en oeuvre, lors de l'étape de positionnement de l'adaptateur au contact du module électronique, un deuxième outillage d'indexation fait coopérer les troisième et cinquième organes de positionnement ou les troisième, quatrième et cinquième organes de positionnement.

Selon un mode de mise en oeuvre, le procédé comprenant en outre une étape de fixation de l'adaptateur au module électronique.

Selon un mode de mise en oeuvre, l'étape de fixation est réalisée par collage.

Selon un mode de mise en oeuvre, l'étape de fixation est réalisée par l'intermédiaire de l'au moins une broche électrique de commande.

Selon un mode de mise en oeuvre, l'étape de fixation du module électronique au dissipateur thermique est réalisée par collage, soudage, brasage ou par frittage.

### BREVE DESCRIPTION DES FIGURES

D'autres particularités et avantages de la présente invention apparaîtront plus clairement à la lecture de la description ci-après, donnée à titre illustratif et non limitatif, et faite en référence aux figures annexées, sur lesquelles :
[Fig.1] est une représentation schématique d'un exemple de mode de réalisation d'un système électronique selon l'invention ;
[Fig.2] illustre un mode de réalisation du référencement du module électronique ;
[Fig.3] est une vue de coupe d'un exemple de mode de réalisation d'un système électronique selon l'invention ;
[[Fig.4] illustre, en vue cavalière, l'association entre les troisième et quatrième organes de positionnement ;
[Fig.5] est une vue de coupe de la figure 4 ;
[Fig.6] illustre, en vue cavalière, l'association entre les troisième et quatrième organes de positionnement suivant une variante de réalisation ;
[Fig.7] est une vue de coupe de la figure 6 ;
[Fig.8] illustre, en vue cavalière, l'association entre les troisième et quatrième organes de positionnement suivant une autre variante de réalisation ;
[Fig.9] est une vue de coupe de la figure 8 ;
[Fig.10] est une vue en coupe d'un mode de réalisation du système électronique illustrant le référencement du module électronique et de l'adaptateur par rapport au dissipateur thermique à l'aide d'un outillage ;
[Fig.11] représente un mode de réalisation particulier de l'adaptateur

Sur les différentes figures, les éléments analogues sont désignés par des références identiques. En outre, les différents éléments ne sont pas nécessairement représentés à l'échelle afin de présenter une vue permettant de faciliter la compréhension de l'invention.

### DESCRIPTION DETAILLEE DE L'INVENTION

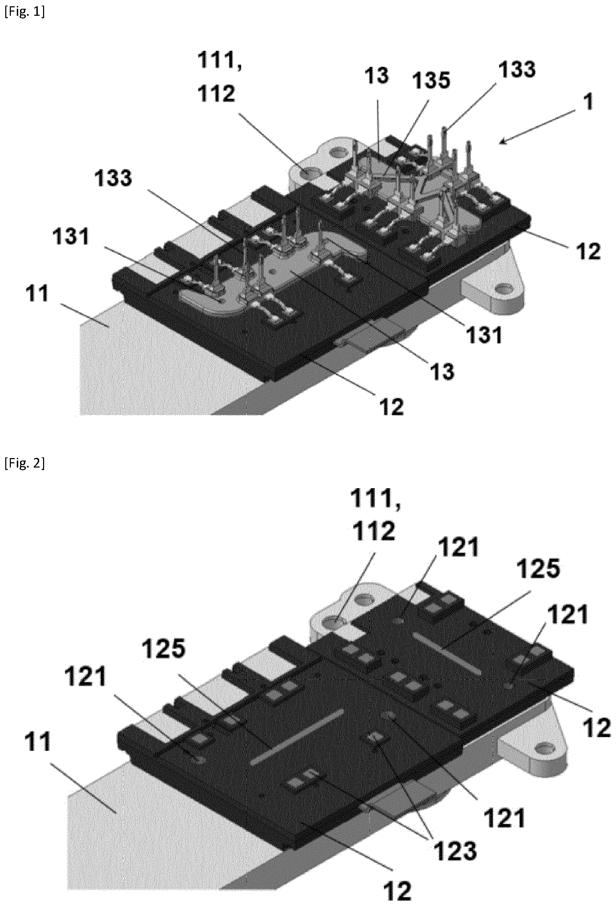

En référence à la figure 1, le système électronique 1 comprend un dissipateur thermique 11, au moins un module électronique 12 et au moins un adaptateur 13.

Dans cet exemple, le système électronique comprend deux modules électroniques 12 comprenant chacun un adaptateur 13, le tout étant monté sur un même dissipateur thermique 11. Un premier module électronique 12 peut comprendre un module de puissance, par exemple, configuré pour alimenter le stator d'une machine électrique tournante. Le deuxième module électronique 12 peut comprendre un module d'excitation, par exemple, configuré pour alimenter le rotor d'une machine électrique tournante.

Le module électronique 12 peut comprendre un module de puissance ou un module d'excitation. Le module électronique 12 est configuré pour être utilisé avec au moins un dispositif électronique, non représenté.

Le module électronique 12 est fixé au dissipateur 11, par exemple, par collage, par brasage, par soudage ou par frittage.

Suivant un mode de réalisation, afin de réduire les dispersions de placement des modules électroniques 12 par rapport au dissipateur thermique 11, chaque module électrique 12 est référencé par rapport audit dissipateur thermique 11. Pour cela, le dissipateur thermique 11 comprend au moins un premier organe de positionnement 111 définissant au moins une position de référence sur le dissipateur thermique 11. Cette position de référence permet de déterminer avec précision l'emplacement du module électronique 12 par rapport au dissipateur thermique 11.

De même, le module électronique 12 comprend au moins un deuxième organe de positionnement 121 configuré pour coopérer avec le premier organe de positionnement 111.

Suivant un mode de réalisation, les premier et deuxième organes de positionnement 111, 121 sont des organes de forme complémentaire coopérant directement entre eux.

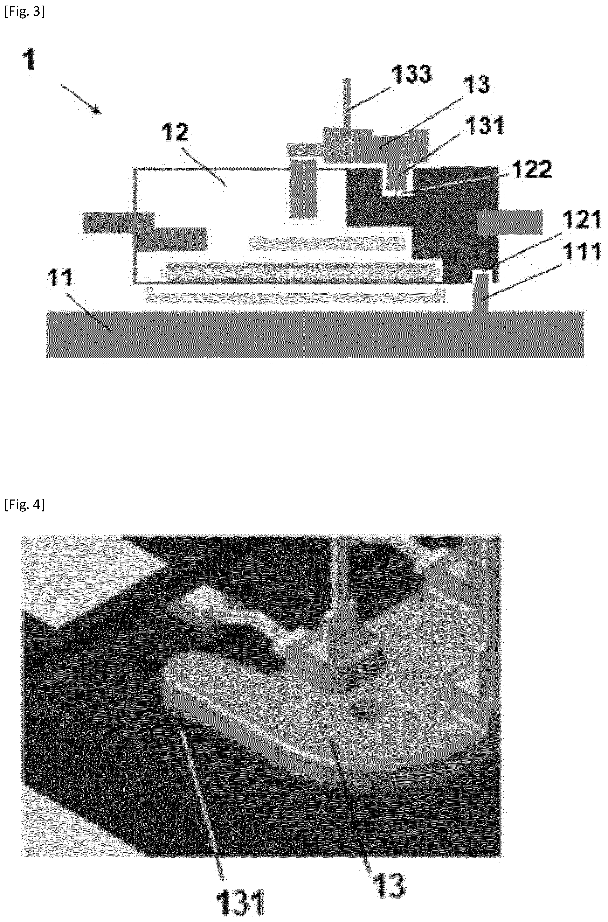

Le premier organe de positionnement 111 est, par exemple, un organe de forme male et le deuxième organe de positionnement 121, un organe de forme femelle. Ce mode de réalisation est, par exemple, illustré sur la figure 3 décrite ci-après. Le premier organe de positionnement 111 peut être un pion ou une excroissance du dissipateur thermique 11. Le deuxième organe de positionnement 121 peut être un orifice ou un trou traversant ou borgne dans le module électronique 12. D'une manière générale, le deuxième organe de positionnement 121, de forme femelle, est agencé pour permettre le passage du premier organe de positionnement 111, de forme male et lui assurer un logement.

Suivant un mode de réalisation alternatif, le premier organe de positionnement 111 est un organe de forme femelle et le deuxième organe de positionnement 121, un organe de forme male.

La figure 2 illustre un autre mode de réalisation dans lequel le premier organe de positionnement 111 et le deuxième organe de positionnement 121 sont des organes de forme femelle. Dans ce mode de réalisation particulier, lors du positionnement du module électronique 12 au contact du dissipateur thermique 11, un premier outillage d'indexation, non représenté, peut être utilisé afin de faire coopérer les premier et deuxième organes de positionnement 111, 121. Le premier outillage d'indexation est agencé pour s'insérer dans les premier et deuxième organes de positionnement 111, 121 et venir aligner le module électronique 12 par rapport au dissipateur thermique 11. Le premier outillage permet ainsi de positionner de façon précise le module électronique 12 par rapport au dissipateur thermique 11.

Pour le mode de réalisation illustré sur la figure 2, le premier outillage d'indexation pourrait être un outil possédant une pluralité de doigts d'indexation, par exemple trois, par exemple quatre, agencés pour s'insérer dans le premier organe de positionnement 111 d'une part et les deux deuxièmes organes de positionnement 121 d'autre part afin de référencer le module électronique 12 par rapport au dissipateur thermique 11.

Dans le mode de réalisation de la figure 2, les premier et deuxième organes de positionnement 111, 121 ne sont pas alignés verticalement, c'est-à-dire non alignés par rapport à la normale au plan défini par la surface du dissipateur 11. Suivant un autre mode de réalisation, les premier et deuxième organes de positionnement 111, 121 sont alignés verticalement. Dans ce mode de réalisation, le premier outillage d'indexation est agencé pour faire coïncider les premier et deuxième organes de positionnement 111, 121 deux à deux.

Suivant un mode de réalisation, les premier et deuxième organes de positionnement 111, 121 sont coaxiaux.

Suivant un mode de réalisation, au moins un module électronique 12 comprend au moins deux deuxièmes organes de positionnement 121, lesdits au moins deux deuxièmes organes de positionnement 121 étant localisés proche ; notamment de l'ordre de quelques millimètres, de deux bords opposés du module électronique 12.

Suivant un mode de réalisation, une pièce de forme male, par exemple un pion ou une vis, est inséré dans les premier et deuxième organes de positionnement 111, 121, de forme femelle, afin d'aligner le module électronique 12 avec le dissipateur thermique 11.

Suivant un mode de réalisation, l'adaptateur 13 est une pièce en matériau électriquement non conducteur comme de la résine ou une matière plastique.

Suivant un mode de réalisation, l'adaptateur 13 est fixé au module électronique 12. L'adaptateur peut être fixé au module électronique à l'aide de colle, par exemple, de la colle époxy.

Suivant un mode de réalisation, l'adaptateur 13 peut comprendre au moins un muret de renfort 135. De façon avantageuse, le muret de renfort 135 permet de renforcer la rigidité de l'adaptateur 13 notamment lorsque ce dernier est de faible épaisseur. Le muret de renfort permet également de résister à certaines contraintes mécaniques comme lors du collage de l'adaptateur sur le module électronique où une pression est exercée sur l'adaptateur 13.

L'adaptateur 13 est configuré pour établir une liaison électrique entre le module électronique 12 et un dispositif électronique par l'intermédiaire d'au moins une broche électrique de commande 133.

De façon avantageuse, l'utilisation d'un adaptateur 13, au sein d'un système électronique 1, permet de regrouper un grand nombre de broches électriques de commande 133 d'un même module électronique 12 sur une même pièce mécanique.

Suivant un mode de réalisation, l'ensemble des broches électriques de commande 133 d'un même module électronique 12 sont regroupées sur un même adaptateur 13.

Suivant un mode de réalisation, les broches électriques de commande 133 sont des broches à emmanchement (ou « *press-fit* » selon la terminologie anglosaxonne).

Suivant un mode de réalisation, le module électronique 12 comprend au moins une zone de connexion 123 configurée pour permettre la connexion d'une extrémité d'une broche électrique de commande 133.

Suivant un mode de réalisation, la zone de connexion 123 est réalisée avec un matériau électriquement conducteur et est configurée de sorte que la connexion de la broche électrique de commande 133 puisse être réalisée avec une marge de positionnement choisie pour compenser les différentes dispersions de placement. La plage de connexion 123 présente, par exemple, une superficie six fois plus grande que la section de de la broche électrique de commande 133.

Afin de positionner de façon précise l'adaptateur 13 en contact avec le module électronique 12, l'adaptateur 13 comprend au moins un troisième organe de positionnement 131. Cet organe de positionnement 131 est configuré pour coopérer avec un quatrième organe de positionnement 122 situé sur le module électronique 12 et/ou avec un cinquième organe de positionnement 112 situé sur le dissipateur thermique 11.

Suivant un mode de réalisation, le au moins un troisième organe de positionnement 131 est proche d'une broche électrique de commande 133, c'est-à-dire situé à moins de dix millimètres d'une broche électrique de commande 133 de l'adaptateur 13.

Suivant un mode de réalisation, l'adaptateur 13 comprend au moins deux troisièmes organes de positionnement 131.

Suivant un mode de réalisation particulier, chacun des au moins deux troisièmes organes de positionnement 131 est situé à une extrémité de l'adaptateur 13. Ce mode de réalisation est, par exemple, illustré sur la figure 1.

Suivant un mode de réalisation, l'adaptateur 13 est référencé par rapport à son module électronique 12 associé afin de réduire les dispersions de placement de l'adaptateur 13 par rapport au module électronique 12. À cet effet, l'adaptateur 13 comprend au moins un troisième organe de positionnement 131 configuré pour coopérer avec un quatrième organe de positionnement 122 situé sur le module électronique 12. Le quatrième organe de positionnement 122 définit une position de référence sur le module électronique 12 afin de positionner, de façon précise, l'adaptateur 13 au contact du module électronique 12.

Suivant un mode de réalisation, les troisième et quatrième organes de positionnement 131, 122 sont des organes de forme complémentaire coopérant directement entre eux. Un des troisième et quatrième organes de positionnement 131, 122 peut être un organe de forme male et l'autre un organe de forme femelle. L'organe de positionnement de forme male peut être un pion ou, d'une manière générale, une excroissance de la pièce sur lequel il est implanté. L'organe de positionnement de forme femelle peut être un orifice ou un trou traversant ou borgne dans la pièce sur lequel il est implanté. D'une manière générale, l'organe de positionnement de forme femelle est agencé pour permettre le passage de l'organe de positionnement de forme male et lui assurer un logement.
De façon avantageuse ce mode de réalisation permet d'effectuer un référencement mécanique simple de l'adaptateur 13 par rapport au module électronique 12.

La figure 3 illustre une vue de coupe d'un mode de réalisation du système électronique 1 dans lequel le troisième organe de positionnement 131 est de forme male et le quatrième organe de positionnement 122 est de forme femelle. De plus, le premier organe de positionnement 111 est de forme male et le deuxième organe de positionnement 121 est de forme femelle.
Dans ce mode de réalisation, le module électronique 12 est référencé par rapport au dissipateur thermique 11 et l'adaptateur 13 est indexé par rapport au module électronique 12. Ainsi, l'adaptateur 13 est également référencé, de façon indirecte, par rapport au dissipateur thermique 11.

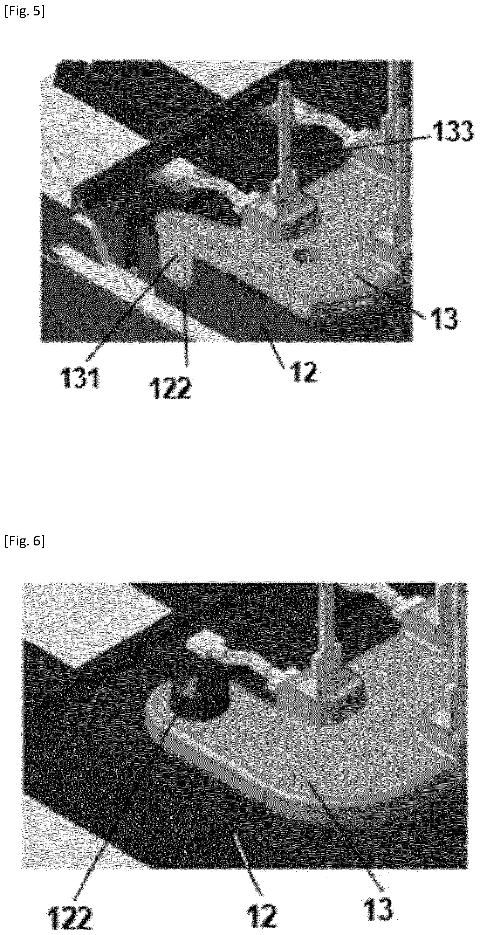

Les figures 4 et 5 illustrent, respectivement en vue cavalière et en vue de coupe, l'association des troisième et quatrième organes de positionnement 131, 122. Cette figure pourrait être un détail du mode de réalisation illustré en figure 3. Dans ce mode de réalisation, le troisième organe de positionnement 131 est un pion cylindrique. Le quatrième organe de positionnement 122 est un trou borgne cylindrique.

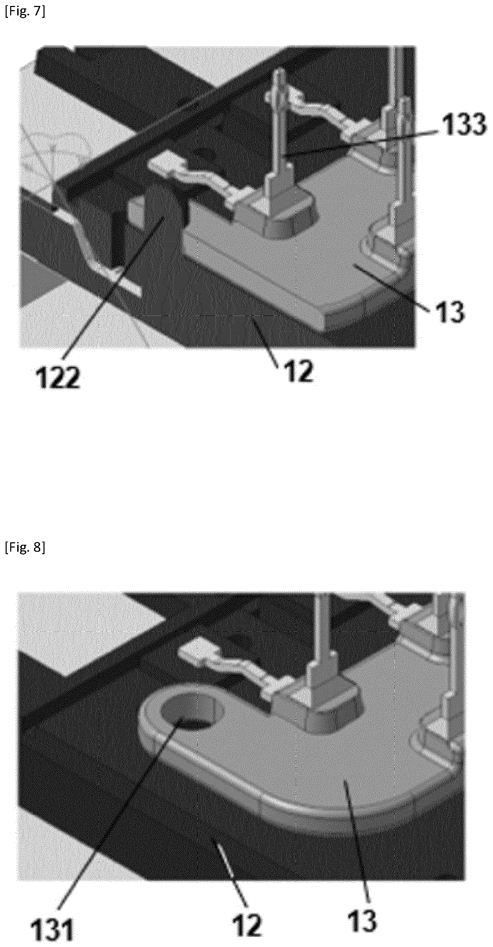

Les figures 6 et 7 illustrent, respectivement en vue cavalière et en vue de coupe, l'association des troisième et quatrième organes de positionnement 131, 122 dans une variante de réalisation. Le troisième organe de positionnement 131 est de forme femelle, à savoir un trou débouchant. Le quatrième organe de positionnement 122 possède une forme male, à savoir, un pion cylindrique.
De façon avantageuse, en plus de permettre de réaliser un référencement mécanique simple de l'adaptateur 13 par rapport au module électronique 12, ce mode de réalisation n'a aucun impact sur l'intérieur du module électronique 12.

Suivant un mode de réalisation, l'adaptateur 13 comprend deux troisièmes organes de positionnement 131 de forme femelle. Un des organes de positionnement 131 est de forme cylindrique et un autre est de forme oblongue. L'organe de positionnement de forme cylindrique est dit « orifice de centrage » et celui de forme oblongue est dit « orifice de placement ».
Selon un aspect de l'invention, la combinaison des orifices de positionnement de forme ronde et oblongue permet un positionnement isostatique de l'adaptateur 13 par rapport au module de puissance 12.

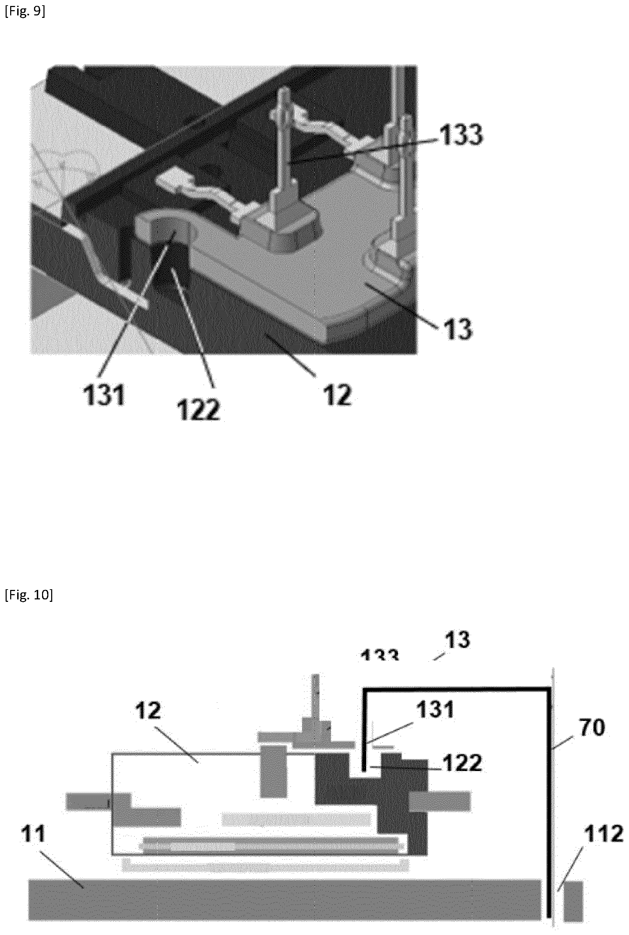

Les figures 8 et 9 représentent, respectivement en vue cavalière et en vue de coupe l'association des troisième et quatrième organes de positionnement 131, 122 dans un autre mode de réalisation. Dans ce mode de réalisation, les troisième et quatrième organes de positionnement 131, 122 sont tous les deux de forme femelle, respectivement un trou traversant et un trou borgne.

Dans ce mode de réalisation, lors du positionnement de l'adaptateur 13 au contact du module électronique 12, un deuxième outillage d'indexation, peut être utilisé afin de faire coopérer chaque couple de troisième et quatrième organes de positionnement 131, 122, respectivement de l'adaptateur et du module électronique. Ce deuxième outillage peut comprendre au moins un doigt d'indexation configuré pour s'insérer dans les troisième et quatrième organes de positionnement 131, 122.

Suivant un mode de réalisation, les troisième et quatrième organes de positionnement 131, 122 sont coaxiaux.

Suivant un mode de réalisation d'un système électronique 1, le troisième organe de positionnement 131 coopère avec le cinquième organe de positionnement 112 situé sur le dissipateur thermique 11 et sur lequel il définit une position de référence. De même, le deuxième organe de positionnement 121 coopère avec le premier organe de positionnement 111 situé sur le dissipateur thermique 11 et sur lequel il définit une position de référence. Ainsi, le module électronique 12 et l'adaptateur 13 sont tous les deux référencés, notamment selon deux étapes distinctes par rapport au dissipateur thermique 11 mais par rapport à des points de référence différents sur le dissipateur 11. Le fixation du module électronique 12 se fait avant l'indexation de adaptateur 13.

Suivant un mode de mise en oeuvre, la coopération des troisième et cinquième organe de positionnement 131, 112 est réalisée par l'intermédiaire d'un deuxième outillage de référencement 70.

La figure 10 illustre un mode de réalisation particulier d'un système électronique 1 selon l'invention. Dans ce mode de réalisation, le module électronique 12 et l'adaptateur 13 sont directement par rapport au dissipateur thermique 11. Le troisième organe de positionnement 131 de l'adaptateur 13 et le quatrième organe de positionnement 121 du module électronique 12 coopèrent avec le cinquième organe de positionnement 112 situé sur le dissipateur thermique 11 et sur lequel il définit une position de référence. De façon avantageuse, ce mode de réalisation permet un positionnement de l'adaptateur 13, et donc de ses broches de commande électrique 133, plus précis qu'avec les modes de réalisation précédemment décrits. Le référencement du module électronique 12 et l'adaptateur 13, par rapport au dissipateur thermique 11, permet d'obtenir les mêmes tolérances de positionnement pour ces deux pièces mécaniques 12, 13.

Le troisième organe de positionnement 131 et le quatrième organe de positionnement 122 peuvent être des organes de forme femelle, par exemple, respectivement un trou traversant et un trou borgne.

Dans ce mode de réalisation particulier, la coopération des troisième, quatrième et cinquième organes de positionnement 131, 122, 112 est réalisée par exemple à l'aide d'un deuxième outillage d'indexation 70. Le deuxième outillage d'indexation 70 est agencé pour s'insérer dans les troisième et quatrième organes de positionnement 131, 122 d'une part et le cinquième organe de positionnement 111 d'autre part afin de centrer l'adaptateur 13 et le module électronique 12 par rapport au dissipateur thermique 11.

Suivant un mode de réalisation, les premier et cinquième organes de positionnement 111, 112 sont confondus. Ce cas est, par exemple, illustré sur les figures 1 et 2.

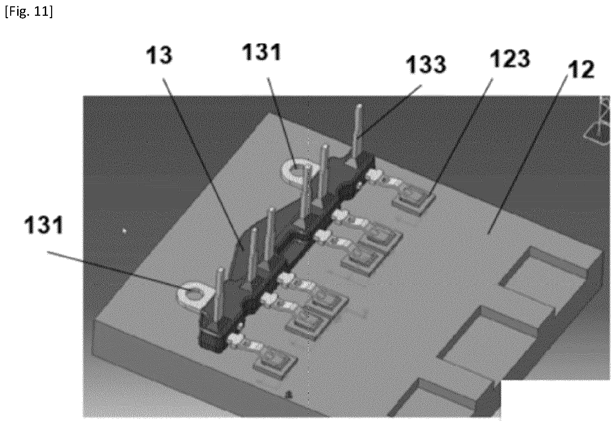

La figure 11 représente un mode de réalisation particulier de l'adaptateur 13 dans lequel les broches électriques de commande 133 sont alignées en rangée. De façon avantageuse, ce mode de réalisation permet de réaliser les broches électriques de commande 133 et les troisième organes de positionnement à partir d'une même feuille de matériau électriquement conducteur, par exemple, du cuivre. Cela permet d'obtenir une meilleure précision de découpe des broches électriques de commande 133. Cela permet également un meilleur positionnement des broches électriques de commande 133 par rapport au mode de réalisation utilisant des broches à emmanchement. En effet, contrairement à l'utilisation de broches à emmanchement, avec ce mode de réalisation on s'affranchit de l'étape de placement des broches électriques 133 et ainsi on réduit les dispersions de placement de ces dernières.

Suivant un mode de réalisation, l'adaptateur 13 comprend au moins deux broches électriques de commande 133. Ces broches électriques de commande 133 sont alignées et surmoulées ensemble dans l'adaptateur 13.

Suivant un mode de réalisation, les broches électriques de commande 133 et le au moins un troisième organe de positionnement 131 de l'adaptateur 13 sont surmoulées ensemble dans l'adaptateur 13.

Suivant un mode de réalisation, l'adaptateur 13 est surmoulées avec un matériau thermoplastique

L'invention a également pour objet un procédé d'assemblage d'un système électronique 1 tel que décrit précédemment. Le procédé comporte les étapes suivantes:
- fournir au moins un dissipateur thermique 11 comprenant au moins un premier organe de positionnement 111 définissant une position de référence sur le dissipateur thermique 11;
- fournir au moins un module électronique 12 comprenant au moins un deuxième organe de positionnement 121 configuré pour coopérer avec le premier organe de positionnement 111;
- positionner le module électronique 12 au contact du dissipateur thermique 11 en faisant coopérer les premier et deuxième organes de positionnement 111,121;
- fixer le module électronique 12 au le dissipateur thermique 11,
- fournir au moins un adaptateur 13 comprenant au moins une broche électrique de commande 133 et configuré pour faire une liaison électrique entre le module électronique 12 et un dispositif électronique, l'adaptateur 13 comprenant au moins un troisième organe de positionnement 131 configuré pour coopérer
- avec un quatrième organe de positionnement 122 situé sur le module électronique, ledit quatrième organe de positionnement 122 définissant une position de référence sur le module électronique 12, et/ou
- avec un cinquième organe de positionnement 112 situé sur le dissipateur thermique 11 ledit cinquième organe de positionnement 112 définissant une position de référence sur le dissipateur thermique 11,
- positionner l'adaptateur 13 au contact du module électronique 12 en faisant coopérer les troisième et quatrième organes de positionnement 131, 122 et/ou les troisième et cinquième organes de positionnement 131, 112.

Suivant un mode de mise en oeuvre du procédé, lors de l'étape de positionnement du module électronique 12, au contact du dissipateur thermique 11, un premier outillage d'indexation fait coopérer les premier et deuxième organes de positionnement 111, 121. Ce premier outillage est ensuite maintenu lors de l'étape de fixation du module électronique 12 au dissipateur thermique 11 puis est retiré.

Suivant un mode de mise en oeuvre, l'étape de fixation du module électronique 12 au dissipateur thermique 11 est réalisée, par exemple, par collage, soudage, brasage ou par frittage des deux pièces mécaniques11, 12.

Suivant un mode de mise en oeuvre du procédé d'assemblage, lors de l'étape de positionnement de l'adaptateur 13 au contact du module électronique 12, un deuxième outillage d'indexation 70 est utilisé afin de faire coopérer les troisième et cinquième organes de positionnement 131, 112.

Suivant un mode de mise en oeuvre du procédé d'assemblage, lors de l'étape de positionnement de l'adaptateur 13 au contact du module électronique 12, un deuxième outillage d'indexation 70 est utilisé afin de faire coopérer les troisième, quatrième et cinquième organes de positionnement 131, 122, 112.

Suivant un mode de mise en oeuvre, le procédé d'assemblage comprend en outre une étape de fixation de l'adaptateur 13 au module électronique 12.

Selon un exemple de mise en oeuvre, la fixation peut être réalisée par collage, par exemple, en utilisant une colle époxy.

Suivant un mode de mise en oeuvre, le procédé d'assemblage comprend, au préalable de l'étape de positionnement de l'adaptateur 13 au contact du module électronique 12, la dépose d'un ruban de colle 125 sur le module électronique 12, comme illustré sur la figure 2. L'étape de fixation peut consister à presser l'adaptateur 13 au contact du module électronique 12 puis à polymériser la colle.

Suivant un mode de mise en oeuvre, une extrémité des broches électriques de commande 132 est fixée aux zones de connexion 123 associées. La fixation peut être réalisée par soudage ultrason ou laser.

Suivant une variante de mise en oeuvre, une extrémité des broches électriques de commande 132 est fixée aux zones de connexion 123 associées mais l'adaptateur 13 n'est pas collé au module électronique 12. La fixation de l'adaptateur 13 au module électronique 12 est donc réalisée par l'intermédiaire d'une extrémité de l'au moins une broche électrique de commande 132.

Suivant un mode de mise en oeuvre, le deuxième outillage est maintenu lors de l'étape de fixation de l'adaptateur 13 au module électronique 12 puis est retiré.

L'invention a été décrite ci-dessus avec l'aide de modes de réalisations présentés sur les figures, sans limitation du concept inventif général.

Bien d'autres modifications et variations se suggèrent d'elles-mêmes à l'homme du métier, après réflexion sur les différents modes de réalisations illustrés dans cette demande.

Ces modes de réalisation sont donnés à titre d'exemple et ne sont pas destinés à limiter la portée de l'invention, qui est déterminée exclusivement par les revendications ci-dessous.

Dans les revendications, le mot « comprenant » n'exclut pas d'autres éléments ou étapes.

Le simple fait que différentes caractéristiques sont énumérées en revendications mutuellement dépendantes n'indique pas qu'une combinaison de ces caractéristiques ne puisse être avantageusement utilisée. Enfin, toute référence utilisée dans les revendications ne doit pas être interprétée comme une limitation de la portée de l'invention.

## Revendications

1. Système électronique (1) **caractérisé en ce qu'**il comprend :
- au moins un dissipateur thermique (11) comprenant au moins un premier organe de positionnement (111) définissant au moins une position de référence sur le dissipateur thermique (11),
- au moins un module électronique (12), configuré pour être utilisé avec un dispositif électronique, le module électronique (12) étant fixé au dissipateur (11) et comprenant au moins un deuxième organe de positionnement (121) configuré pour coopérer avec le premier organe de positionnement (111),
- un adaptateur (13) comprenant au moins une broche électrique de commande (133) et configuré pour faire une liaison électrique entre le module électronique et un dispositif électronique, l'adaptateur (13) comprenant au moins un troisième organe de positionnement (131) configuré pour coopérer
- avec un quatrième organe de positionnement (122) situé sur le module électronique (12), ledit quatrième organe de positionnement (122) définissant une position de référence sur le module électronique (12), et/ou
- avec un cinquième organe de positionnement (112) situé sur le dissipateur thermique (11) ledit cinquième organe de positionnement (112) définissant une position de référence sur le dissipateur thermique (11).

2. Système électronique (1) selon la revendication précédente, dans lequel les premier et cinquième organes de positionnement (111, 112) sont confondus.

3. Système électronique (1) selon l'une des revendications 1 ou 2, dans lequel le au moins un troisième organe de positionnement (131) est situé à moins de dix millimètres d'une broche électrique de commande (133) de l'adaptateur (13).

4. Système électronique (1) selon l'une des revendications précédentes, dans lequel l'adaptateur (13) comprend au moins deux troisièmes organes de positionnement (131), chacun des au moins deux troisièmes organes de positionnement (131) étant situé à une extrémité de l'adaptateur (13).

5. Système selon la revendication précédente dans lequel un des au moins deux troisièmes organes de positionnement (131) est de forme cylindrique et un des au moins deux troisièmes organes de positionnement (131) est de forme oblongue.

6. Système électronique (1) selon l'une des revendications précédentes, dans lequel l'adaptateur (13) comprend au moins deux broches électriques de commande (133), lesdites broches électriques de commande (133) étant alignées et surmoulées ensemble dans l'adaptateur (13).

7. Système électronique (1) selon la revendication précédente, dans lequel les broches électriques de commande (133) et le au moins un deuxième organe de positionnement (131) de l'adaptateur (13) sont surmoulées ensemble dans l'adaptateur (13).

8. Procédé d'assemblage d'un système électronique (1) comportant les étapes suivantes:
- fournir au moins un dissipateur thermique (11) comprenant au moins un premier organe de positionnement (111) définissant une position de référence sur le dissipateur thermique (11);
- fournir au moins un module électronique (12) comprenant au moins un deuxième organe de positionnement (121) configuré pour coopérer avec le premier organe de positionnement (111);
- Positionner le module électronique (12) au contact du dissipateur thermique (11) en faisant coopérer les premier et deuxième organes de positionnement (111, 121),
- fixer le module électronique (12) avec le dissipateur thermique (11),
- fournir au moins un adaptateur (13) comprenant au moins une broche électrique de commande (133) et configuré pour faire une liaison électrique entre le module électronique (12) et un dispositif électronique, l'adaptateur (13) comprenant au moins un troisième organe de positionnement (131) configuré pour coopérer:
- avec un quatrième organe de positionnement (122) situé sur le module électronique (12), ledit quatrième organe de positionnement (122) définissant une position de référence sur le module électronique (12), et/ou
- avec un cinquième organe de positionnement (112) situé sur le dissipateur thermique (11) ledit cinquième organe de positionnement (112) définissant une position de référence sur le dissipateur thermique (11),
- positionner l'adaptateur (13) au contact du module électronique (12) en faisant coopérer les troisième et cinquième organes de positionnement (131, 112) et/ou les troisième et quatrième organes de positionnement (131, 122).

9. Procédé d'assemblage selon la revendication précédente dans lequel, lors de l'étape de positionnement du module électronique (12) au contact du dissipateur thermique (11), un premier outillage d'indexation fait coopérer les premier et deuxième organes de positionnement (111, 121).

10. Procédé d'assemblage selon l'une des revendications 8 ou 9 dans lequel, lors de l'étape de positionnement de l'adaptateur (13) au contact du module électronique (12), un deuxième outillage d'indexation fait coopérer les troisième et cinquième organes de positionnement (131, 112) ou les troisième, quatrième et cinquième organes de positionnement (131, 122, 112).

11. Procédé d'assemblage selon l'une des revendications 8 à 10 comprenant en outre une étape de fixation de l'adaptateur (13) au module électronique (12).
